# EUROPEAN PATENT SPECIFICATION

(11) **EP 2 249 429 B1**
(45) Date of publication and mention of the grant of the patent: **21.05.2014**
(21) Application number: 09707946.1
(22) Date of filing: 02.02.2009
(51) Int. Cl.: H01M 14/00, H01L 31/04, H01G 9/20, H01L 51/44

(54) **DYE-SENSITIZED SOLAR CELL**
FARBSTOFFSENSIBILISIERTE SOLARZELLE
CELLULE SOLAIRE SENSIBILISÉE PAR COLORANT

(30) Priority: 06.02.2008 JP 2008026817
(43) Date of publication of application: 10.11.2010
(73) Proprietor: FUJIKURA LTD., Kohtoh-ku Tokyo 135-0042 (JP)
(72) Inventor: OKADA, Kenichi, Sakura-shi Chiba 285-8550 (JP); MATSUI, Hiroshi, Sakura-shi Chiba 285-8550 (JP); KITAMURA, Takayuki, Sakura-shi Chiba 285-8550 (JP)
(74) Representative: HOFFMANN EITLE
(86) International application number: PCT/JP2009/000389
(87) International publication number: WO 2009/098857

(56) References cited:
- WO-A1-2004/100196
- JP-A- 8 287 969
- JP-A- 2002 260 746
- JP-A- 2003 346 927
- JP-A- 2005 078 857
- JP-A- 2006 261 089
- US-A1- 2005 166 957

## Description

### TECHNICAL FIELD

The present invention relates to a dye-sensitized solar cell that includes a wiring part adjacent to a porous oxide semiconductor layer.

### BACKGROUND ART

A dye-sensitized solar cell uses an electrolyte that erodes metal. For this reason, if collective wiring for reducing the collective resistance of a cell is provided, a wiring protective layer for protecting the collective wiring from the electrolyte is required. However, if the wiring protective layer is formed on both side portions of the collective wiring, the thickness of the wiring protective layer is added to the width of the wiring. For this reason, the width of the entire wiring tends to increase.

Since a silicon-based solar cell in the related art does not use an electrolyte, the wiring protective layer is not necessary. Accordingly, the surface of the collective wiring has metal luster due to its exposed metal surface. Therefore, even though entering a wiring portion, incident light is reflected by the surface of the wiring and light is scattered in a panel. As a result, it may be possible to effectively use the energy of incident light. However, in the dye-sensitized solar cell, light entering the wiring portion is absorbed in the cell and is converted into heat for the following reasons disclosed in (1) and (2). Accordingly, there is a drawback that the use efficiency of light is significantly decreased due to energy loss.
(1) The wiring of the dye-sensitized solar cell is generally made of a silver paste that contains low melting point glass as a binder, and low melting point glass generally has a dark color. For this reason, the color of the surface becomes dark after the formation of the wiring, so that light entering the wiring portion is absorbed.
(2) A material used in the wiring protective layer is also generally transparent or has a dark color. Accordingly, light is absorbed by a dark-colored wiring protective layer or a dark-colored electrolyte existing on the back side of a transparent wiring protective layer.

A method of guiding incident light to a power generating part by a lens or the like has been considered in order to reduce the loss due to a non-power generating part formed by wiring. For example, a prismatic cover is disclosed in Non-patent Document 1. Further, a method using a condenser lens array is disclosed in Patent Documents 1 and 2.

In Patent Document 3, a lens is formed at a transparent portion between solar cell elements in order to make the illuminance of transmitted light be uniform when light entering between solar cell elements of a solar cell module is made to pass through the back surface of the solar cell module and is used in daylighting.

A dye-sensitized solar cell where a phosphor is disposed on a transparent substrate of a dye-sensitized solar cell is described in Patent Document 4. The dye-sensitized solar cell increases power generation efficiency by converting a part of incident light into light that has a wavelength corresponding to high photoelectric conversion quantum efficiency.
Non-patent Document 1: Hamakawa Yoshihiro and Kuwano Yukinori, ADVANCED ELECTRONICS SERIES I-3, "solar energy engineering; solar cell", BAIFUKAN CO., LTD, 1994, 4-1-5 high-efficiency single-crystalline silicon solar cell, p. 93-94.
Patent Document 5 describes a photoelectric transducer including a first electrode; a charge-separating means in contact with the first electrode; a second electrode in contact with the charge-separating means; and a light-guiding means such as a convex lens guiding incident light to a transparent portion provided in a low-resistance region of the second electrode, the light-guiding means guiding the incident light to the charge-separating means.
Patent Document 1: International Publication No. 98/31054
Patent Document 2: Japanese Patent Application Laid-Open (JP-A) No. 10-51020
Patent Document 3: JP-A No. 11-135813
Patent Document 4: JP-A No. 2004-171815
Patent Document 5: US 2005/0166957 A1

### DISCLOSURE OF THE INVENTION

### PROBLEM TO BE SOLVED BY THE INVENTION

However, in the methods disclosed in Non-patent Document 1 and Patent Documents 1 and 2, the cost of the lens array or the cover is large and exclusive design is needed. For this reason, the methods could not be easily applied so as to correspond to the shapes of various cells. The low degree of freedom in design may lose advantages of a dye-sensitized solar cell that allows colors or shapes thereof to be variously changed and to realize making various kinds of products in small lots.

The solar cell module disclosed in Patent Document 3 uses light, which is transmitted through the lens, in daylighting on the back side of the module, and does not use the light in the power generation of the solar cell element.

The solar cell module disclosed in Patent Document 4 improves power generation efficiency in light absorption using a high-concentration iodine electrolyte. However, the particular coping of the metal wiring layer is not disclosed.

An object of the present invention is to provide a dye-sensitized solar cell that can improve power generation efficiency by suppressing light absorption of a wiring part.

### MEANS FOR SOLVING THE PROBLEM

In order to achieve the above-mentioned object, a the present invention provides a dye-sensitized solar cell according to claim 1.

According to the dye-sensitized solar cell, the direction of light entering the wiring part, which is a non-power generating part, can be changed to be directed to the porous oxide semiconductor layer on which a dye, that is, the power generating part is carried, by the incident light direction changing part.

The incident light direction changing part is a film.

The film may be at least one of, for example, a diffusion film, a diffraction grating film, a fluorescent coating film, and a reflective film.

The incident light direction changing part is preferably provided on a line, which connects the first electrode substrate, the wiring part, and the second electrode substrate, and provided on a line along a thickness direction of the first or second electrode substrate.

The above dye-sensitized solar cell may have a structure where the first electrode substrate is a transparent electrode substrate and the incident light direction changing part is provided on the opposite side of the wiring part with respect to the first electrode substrate.

Further, the above dye-sensitized solar cell may have a structure where the first electrode substrate is a transparent electrode substrate, the wiring part includes a collective wiring and a wiring protective layer that is provided so as to cover the collective wiring, and the wiring protective layer includes the incident light direction changing part.

Furthermore, the above dye-sensitized solar cell may have a structure where the first electrode substrate is a transparent electrode substrate, the wiring part includes a collective wiring and a wiring protective layer that is provided so as to cover the collective wiring, and the incident light direction changing part is provided between the collective wiring and the first electrode substrate.

In addition, the above dye-sensitized solar cell may have a structure where the second electrode substrate is a transparent electrode substrate, and the incident light direction changing part is provided on the opposite side of the first electrode with respect to the second electrode substrate.

Moreover, the above dye-sensitized solar cell may have a structure where the second electrode substrate is a transparent electrode substrate, the wiring part includes a collective wiring and a wiring protective layer that is provided so as to cover the collective wiring, and the wiring protective layer includes the incident light direction changing part.

The width of the film is larger than the width of the wiring part and the film is disposed in a range that does not overlap the adjacent porous oxide semiconductor layer.

### EFFECT OF THE INVENTION

According to the present invention, the direction of light entering the wiring part, which is a non-power generating part, can be changed to be directed to the porous oxide semiconductor layer on which a dye, that is, the power generating part is carried, by the incident light direction changing part.

### BRIEF DESCRIPTION OF THE DRAWINGS

Fig. 1 is a cross-sectional view showing a dye-sensitized solar cell according to a first embodiment of the present invention.
Fig. 2 is a cross-sectional view showing a dye-sensitized solar cell according to a second embodiment, not forming part of the invention.
Fig. 3 is a cross-sectional view showing a dye-sensitized solar cell according to a third embodiment of the present invention.
Fig. 4 is a cross-sectional view showing a dye-sensitized solar cell according to a fourth embodiment, not forming part of the invention.
Fig. 5 is a cross-sectional view showing a dye-sensitized solar cell according to a fifth embodiment of the present invention.
Fig. 6 is a plan view illustrating the arrangement of collective wiring between a plurality of cells.

### Reference Numerals

L incident light
S light of which direction is changed by film
R light that is reflected again by surface of substrate
10, 20, 30, 40 dye-sensitized solar cell
11, 21, 31, 41 transparent electrode substrate
12, 22, 32, 42 transparent conductive film
13, 23, 33, 43 collective wiring
14, 34 wiring protective layer
15, 25, 35, 45 porous oxide semiconductor layer in which dye is carried
16, 26, 36, 46 electrode substrate
17, 27, 37, 47 electrolyte layer
18, 28, 38 film that changes direction of incident light (incident light direction changing part),
24, 44 wiring protective layer that also functions as film changing direction of incident light

### BEST MODE FOR CARRYING OUT THE INVENTION

The present invention will be described below with reference to drawings, on the basis of a preferred embodiment.

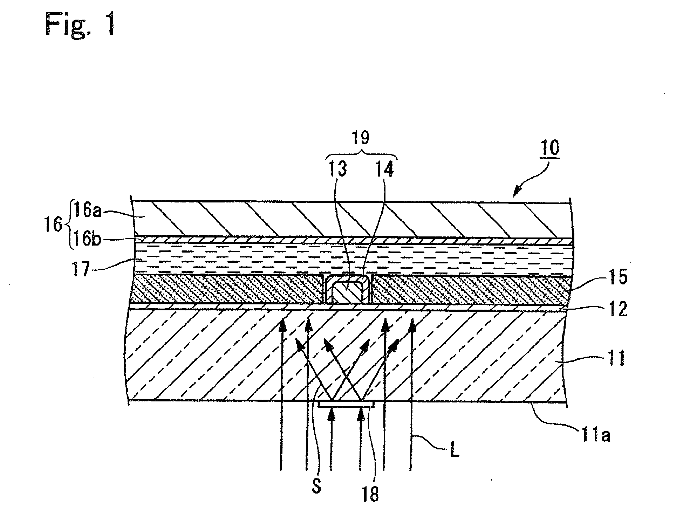

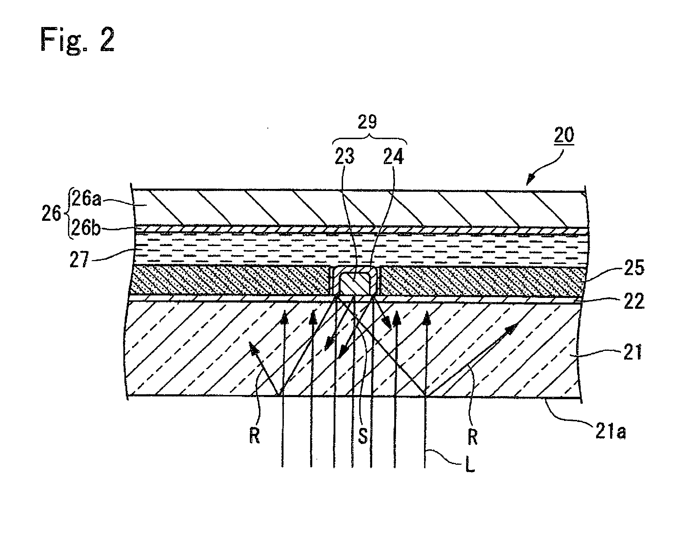

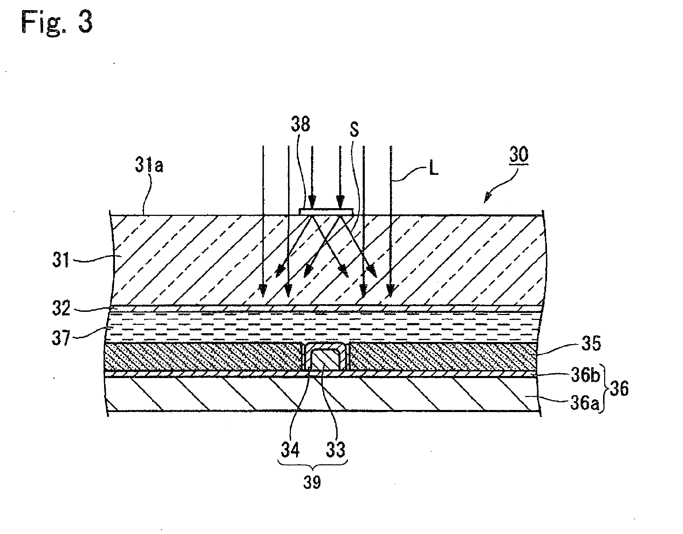

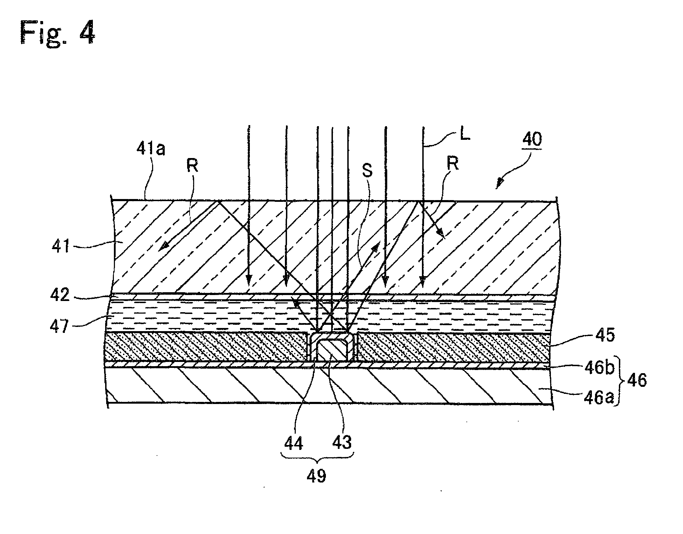

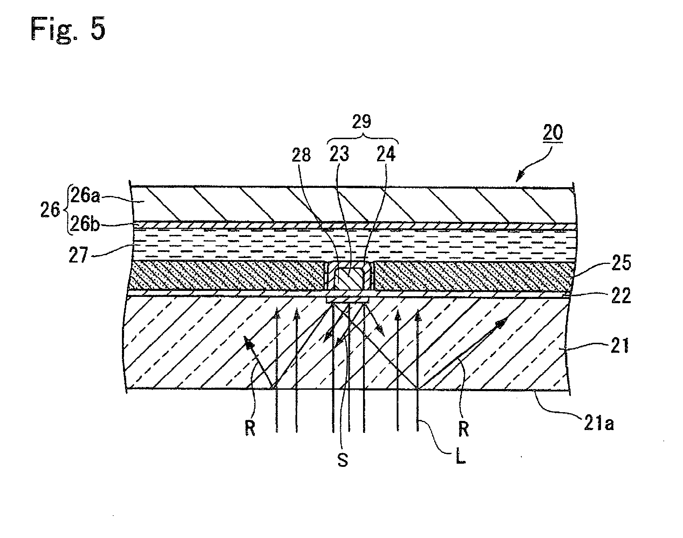

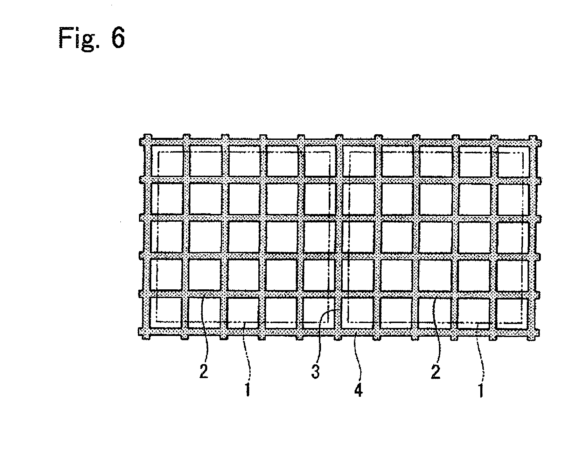

Fig. 1 is a cross-sectional view showing a dye-sensitized solar cell according to a first embodiment of the present invention. Fig. 2 is a cross-sectional view showing a dye-sensitized solar cell according to a second embodiment, not forming part of the invention. Fig. 3 is a cross-sectional view showing a dye-sensitized solar cell according to a third embodiment of the present invention. Fig. 4 is a cross-sectional view showing a dye-sensitized solar cell according to a fourth embodiment, not forming part of the invention. Fig. 5 is a cross-sectional view showing a dye-sensitized solar cell according to a fifth embodiment of the present invention. Fig. 6 is a plan view illustrating the disposition of collective wiring between a plurality of cells.

A dye-sensitized solar cell 10 shown in Fig. 1 includes at least a first electrode substrate 11, a transparent conductive film 12 that is formed on the first electrode substrate 11, a wiring part 19 that is formed on the transparent conductive film 12, a porous oxide semiconductor layer 15 that is provided adjacent to the wiring part 19 on the transparent conductive film 12, a second electrode substrate 16 that is disposed so as to face the porous oxide semiconductor layer 15 of the first electrode substrate 11, and an electrolyte layer 17 that is disposed between the electrode substrates 11 and 16. The wiring part 19 includes collective wiring 13 that is formed on the transparent conductive film 12, and a wiring protective layer 14 that is formed so as to cover the collective wiring 13. Further, the first electrode substrate 11, which is a transparent electrode substrate, includes a film 18, which changes the direction of incident light, at a position corresponding to the wiring part 19.

A dye-sensitized solar cell 20 shown in Fig. 2 includes at least a first electrode substrate 21, a transparent conductive film 22 that is formed on the first electrode substrate 21, a wiring part 29 that is formed on the transparent conductive film 22, a porous oxide semiconductor layer 25 that is provided adjacent to the wiring part 29 on the transparent conductive film 22, a second electrode substrate 26 that is disposed so as to face the porous oxide semiconductor layer 25 of the first electrode substrate 21, and an electrolyte layer 27 that is disposed between the electrode substrates 21 and 26. The wiring part 29 includes collective wiring 23 that is formed on the transparent conductive film 22, and a wiring protective layer 24 that is formed so as to cover the collective wiring 23. Further, the wiring protective layer 24 is disposed at a position corresponding to the wiring part 29, and has a function to change the direction of incident light. That is, in the dye-sensitized solar cell 20, the wiring protective layer 24 also functions as a film that is disposed at a position corresponding to the wiring part 29 and changes the direction of incident light. In other words, the film 24 is provided at the wiring part 29.

A dye-sensitized solar cell 30 shown in Fig. 3 includes at least a first electrode substrate 36, a wiring part 39 that is formed on the first electrode substrate 36, a porous oxide semiconductor layer 35 that is provided adjacent to the wiring part 39 on the first electrode substrate 36, a second electrode substrate 31 that is disposed so as to face the porous oxide semiconductor layer 35 of the first electrode substrate 36, a transparent conductive film 32 that is formed on the second electrode substrate 31, and an electrolyte layer 37 that is disposed between the electrode substrates 31 and 36. The wiring part 39 includes collective wiring 33 that is formed on the first electrode substrate 36, and a wiring protective layer 34 that is formed so as to cover the collective wiring 33. Further, the second electrode substrate 31, which is a transparent electrode substrate, includes a film 38, which changes the direction of incident light, at a position corresponding to the wiring part 33.

In the present invention, the film bodies 18, 24, 38, and 44, which change the direction of incident light, are provided at positions corresponding to the wiring parts 19, 29, 39, and 49, respectively. That is, if the film bodies 18, 24, 38, and 44 are not provided, incident light, which enters and is absorbed in the collective wirings 13, 23, 33, and 43 or the wiring protective layers 14, 24, 34, and 44, enters the film bodies 18, 24, 38, and 44. The direction of the incident light, which enters the film bodies 18, 24, 38, and 44, is changed by the film bodies 18, 24, 38, and 44, and at least a part of the incident light enters the porous oxide semiconductor layers 15, 25, 35, and 45 that are power generating parts. Accordingly, it may be possible to suppress the energy loss of incident light and to improve power generation efficiency.

In the dye-sensitized solar cell 10 according to the first embodiment shown in Fig. 1, the first electrode substrate 11 provided with porous oxide semiconductor layer 15 is a transparent electrode substrate and incident light L enters the dye-sensitized solar cell through the first electrode substrate 11. In the dye-sensitized solar cell 10, the film 18 changing the direction of the incident light L is provided at a position that corresponds to the collective wiring 13 on the surface 11a of the first electrode substrate 11, that is, on the surface 11a of the first electrode substrate 11 opposite to the collective wiring 13. A diffusion film, a diffraction grating film, or a fluorescent coating film may be used as the film 18. In this case, light S, which is obtained by changing the direction of the incident light L by the film 18, may enter the porous oxide semiconductor layer 15.

In the dye-sensitized solar cell 20 according to the second embodiment shown in Fig. 2, not forming part of the invention, the first electrode substrate 21 provided with the porous oxide semiconductor layer 25 is a transparent electrode substrate and incident light L enters the dye-sensitized solar cell through the first electrode substrate 21. In the dye-sensitized solar cell 20, the wiring protective layer 24 provided on the surface of the collective wiring 23 also functions as a film 24 that changes the direction of incident light L. A reflective film, which increases the reflectance of the surface of the wiring, may be used as the film 24. In this case, light S, which is reflected by the wiring protective layer 24 including a reflective film, is reflected again by a surface 21a of the first electrode substrate 21, and the reflected light R may enter the porous oxide semiconductor layer 25. Further, light, which has entered the film 24, may also enter the porous oxide semiconductor layer 25 through the electrolyte layer 27. Meanwhile, in the past, the surface reflectance of the collective wiring 23 formed using a conductive paste is low. For this reason, the incident light is difficult to be reflected from the collective wiring 23 toward the first electrode substrate 21. Accordingly, if the surface reflectance of the collective wiring 23 is low, it is preferable that a film 28 for increasing reflectance be formed between the first electrode substrate 21 and the transparent conductive film 22 in the dye-sensitized solar cell 20 as shown in Fig. 5. Here, a diffusion film, a diffraction grating film, or a fluorescent coating film may be used as the film 28. In this case, light L entering the collective wiring 23, is reflected by the film 28, the reflected light S is reflected again by the surface 21a of the first electrode substrate 21, and the light R, which is reflected again, can enter the porous oxide semiconductor layer 25. Therefore, it may be possible to increase the use efficiency of light that enters the dye-sensitized solar cell toward the collective wiring 23.

In the dye-sensitized solar cell 30 according to the third embodiment shown in Fig. 3, the second electrode substrate 31, which is disposed so as to face the porous oxide semiconductor layer 35 of the first electrode substrate 36, is a transparent electrode substrate and incident light L enters the dye-sensitized solar cell through the first electrode substrate 31. In the dye-sensitized solar cell 30, the film 38, which changes the direction of incident light L, is provided on a surface 31a of the second electrode substrate 31 at a position that overlap the collective wiring 33. That is, the film 38 is provided on a line, which connects the first electrode substrate 36, the second electrode substrate 31, and the wiring part 39, on the surface 31a of the second electrode substrate 31 opposite to the collective wiring 33. A diffusion film, a diffraction grating film, or a fluorescent coating film may be used as the film 38. In this case,light S, which is obtained by changing the direction of the incident light L by the film 38, may enter the porous oxide semiconductor layer 35.

Meanwhile, as in a dye-sensitized solar cell 40 according to a fourth embodiment not forming part of the invention, (see Fig. 4) where a second electrode substrate 41, which is disposed so as to face a porous oxide semiconductor layer 45 of a first electrode substrate 46, is a transparent electrode substrate and incident light L enters the dye-sensitized solar cell through the second electrode substrate 41, a wiring protective layer 44 provided on the surface of a collective wiring 43 may also function as a film that changes the direction of incident light L. A reflective film, which increases the reflectance of the surface of the wiring, may be used as the film. In this case, light S, which is reflected by the wiring protective layer 44 including a reflective film, is reflected again by the surface of the second electrode substrate 41, and the reflected light R may enter the porous oxide semiconductor layer 45.

Further, if both the first and second electrode substrates are formed of a transparent electrode substrate, any one of the above-mentioned first to fourth embodiments may be applied.

Further, in the embodiments shown in Figs. 1 to 4, there has been provided a film that changes the direction of incident light so as to correspond to the position of the wiring part (see Fig. 6) including the collective wiring 2 provided at a portion of each cell 1 of the dye-sensitized solar cell. However, the present invention is not limited thereto. The film changing the direction of incident light may be disposed so as to correspond to the position of the collective wiring that is disposed at a portion adjacent to the porous oxide semiconductor layer in which a dye is carried. The film may be disposed so as to correspond to the position of collective wiring 3 that is disposed between a plurality of cells 1 and 1. Further, the film may be disposed so as to correspond to the position of collective wiring 4 that is disposed at the peripheral outer portion of the cells 1. If the position of the film is a position adjacent to the porous oxide semiconductor layer, which carries a dye and forms a power generating part, at a distance of about 2 mm or less, the incident light, of which the direction is changed by the film, may preferably enter the power generating part.

The diffusion film is not particularly limited. However, as the diffusion film, there may be a diffusion film that is formed so as to scatter incident light by adding transparent beads of which the refractive index is different from the refractive index of a transparent resin, scattering particles of which the refractive index is higher than the refractive index of the transparent resin, or the like to the transparent resin, for example. The diffusion film may be an isotropic film or an ansiotropic film, and it is preferable that the diffusion film scatter light in a direction perpendicular to the wiring (that is, in a horizontal direction in Figs. 1 and 3). A diffusion film is formed by attaching, for example, a film, which is previously formed, to the surface of a substrate. Alternatively, a diffusion film may also be formed by applying ink or a paste-like material to the surface of a substrate and drying or hardening the ink or the paste-like material. It is preferable that the diffusion film have high transmittance of light and a large scattering angle.

The diffraction grating film is not particularly limited. However, as the diffraction grating film preferably used is the diffraction grating film of which the number of grids and the diffraction direction are set so that the direction of light, which has a wavelength of 500 to 600 nm (for example, a wavelength of 550 nm) and high photoelectric conversion quantum efficiency, of incident light is changed and the light enters the porous oxide semiconductor layer. A diffraction grating film is formed by attaching a film, where a diffraction grating is previously formed, to the surface of a substrate. Alternatively, a diffraction grating film may also be formed by forming a film on the surface of a substrate through the attachment of a film or the formation of a coating film and then forming a diffraction grating on the film.

The fluorescent coating film is not particularly limited. However, it is preferable that the following fluorescent coating film be used as the fluorescent coating film. That is, the fluorescent coating film uses a material, which efficiently emits light having a wavelength of 500 to 600 nm (for example, a wavelength of 550 nm) and high photoelectric conversion quantum efficiency, as a phosphor. As a first example of the fluorescent coating film, there may be a film that is formed by applying a solution where a phosphor is dissolved or dispersion liquid where a phosphor is dispersed to a transparent substrate and drying the solution or the dispersion liquid. As a second example of the fluorescent coating film, there may be a film that is formed by attaching a plastic film, which contains a phosphor, to the surface of a transparent substrate. The plastic film is made of a material, which is obtained by adding a phosphor to a transparent resin, such as an acrylic resin, a urethane resin, or a cellulose-based resin, and formed in the shape of a film. As a third example of the fluorescent coating film, there may be a film that is formed by attaching a plastic film, to which a phosphor is applied, to the surface of a transparent substrate. The plastic film is formed by applying a solution such as fluorescent coating, where a phosphor is dissolved, to a transparent plastic film, such as a polyethylene terephthalate film or a cellulose-based resin film, and drying the solution.

As the phosphor in the fluorescent coating film, there is used a phosphor that has a function to convert light having a wavelength of at least 500 nm or less into light having a wavelength of 500 to 600 nm. Specifically, there are organic phosphors, such as fluorescein (490 nm→520 nm), eosin, and rhodamine B; inorganic phosphors, such as calcium halo-phosphate and cadmium telluride. Further, an inorganic phosphor having high heat resistance may be melted and contained in glass that forms a transparent substrate. If a transparent substrate is formed of a plastic film, an inorganic phosphor having high heat resistance may be kneaded in the transparent substrate. The concentration of a phosphor in the fluorescent coating film is sufficient in the range of about 0.1 to 1 wt%, and it is preferable to adjust the amount of the added phosphor so that light absorption caused by the phosphor itself is not excessively increased. Furthermore, the thickness of the fluorescent coating film is not particularly limited. However, it is preferable that the thickness of the fluorescent coating film be small.

The reflective film is not particularly limited. However, as the reflective film, there may be a coating film or the like that is whitened by previously mixing high refractive index particles, which are made of a titanium oxide or the like, in ink for forming a wiring protective film. It is preferable that the average particle size of the high refractive index particle be in the range of 200 to 600 nm. Further, as for the coating film, it is preferable to disperse ink well so that aggregated secondary particles having a particle size of 1 µm or more cannot be generated.

Even in all of the above-mentioned cases, the widths of the film bodies 18, 24, 38, and 44 changing the direction of incident light is larger than those of the wiring parts 19, 29, 39, and 49 and the film bodies be disposed in the ranges not overlapping the adjacent porous oxide semiconductor layers 15, 25, 35, and 45. Accordingly, even though the film bodies are not provided, the incident light, which reaches the power generating parts, that is, the porous oxide semiconductor layers 15, 25, and 35, is not prevented from reaching the power generating parts. Accordingly, it may be possible to make the incident light, which is to reach non-power generating parts if the film bodies are not provided, efficiently reach the power generating parts. Further, the provision of the film on the surface of the substrate may also be applied to non-power generating parts such as connectors or portions between cells.

Furthermore, when the film bodies 18 and 38 are provided on the surfaces 11a and 31a of the transparent electrode substrates 11 and 31 becoming window electrodes as shown in Figs. 1 and 3, it is preferable that a positional relationship between the film bodies 18 and 38 and the collective wiring 13 and 33 be set so as to correspond to a light incident direction. Usually, when it is supposed that incident light L enters the transparent electrode substrates 11 and 31 so as to be perpendicular to the transparent electrode substrates, the film bodies 18 and 38 and the collective wiring 13 and 33 may be disposed substantially perpendicular to the surface of the substrates (in a vertical direction in Figs. 1 and 3). In other words, the film bodies 18 and 38 may be disposed on the lines, which connect the transparent electrode substrates 11 and 31 with the wiring parts 19 and 39, and on the lines along the thickness directions of the transparent electrode substrates 11 and 31. The reason why the film bodies 18 and 38 are disposed at the above-mentioned positions is as follows: That is, the surfaces 11a and 31a of the transparent electrode substrates 11 and 31 usually face the positions where the height of the sun is maximum. Here, when the height of the sun becomes maximum, the amount of insolation of sunlight becomes maximum. Accordingly, if the film bodies 18 and 38 are not provided, the intensity of light entering the wiring parts 19 and 39 becomes maximum and power generation loss also becomes maximum when the incident angle of sunlight becomes maximum. Accordingly, if the film bodies 18 and 38 are disposed at the above-mentioned positions, the power generation loss per day is suppressed to the lowest level. This is particularly significant when the weather is fine.

Meanwhile, even though the film bodies 18 and 38 are disposed as described above, it may also be possible to respond to a case where incident light L enters obliquely from a specific direction.

As long as a substantially transparent substrate is formed, glass, a resin, ceramics, and the like may be used as the base materials of the transparent electrode substrates 11, 21, 31, and 41 without limitation. When the porous oxide semiconductor layer is fired, it is particularly preferable to use high-strain-point glass in terms of excellence in heat resistance so that the deformation, metamorphosis, and the like of the substrate do not occur. However, it is also preferable to use soda lime glass, glass which is made of soda lime and whose iron component is less than that of ordinary soda lime glass, borosilicate glass, and the like.

The materials of the transparent conductive films 12, 22, 32, and 42 are not particularly limited. However, conductive metal oxides, for example, a tin-doped indium oxide (ITO), a tin oxide (SnO₂), and a fluorine-doped tin oxide (FTO) may be used as the materials of the transparent conductive films. A well-known appropriate method corresponding to the material may be used as a method of forming the transparent conductive film. For example, sputtering, deposition, SPD, CVD, and the like may be used as the method of forming the transparent conductive film. Further, the transparent conductive film is usually formed in a thickness of about 0.001 µm to 10 µm in consideration of optical transparency and electrical conductivity.

The collective wiring 13, 23, and 33 is obtained by forming metal, such as gold, silver, copper, platinum, aluminum, nickel, and titanium, as wiring by, for example, a grid-like pattern, a striped pattern, and a comb-like pattern. In order not to significantly deteriorate the optical transparency of the electrode substrate, it is preferable to finely form the wiring so that the width of each wiring be 1000 µm or less. The thickness (height) of each wiring is not particularly limited. However, it is preferable that the thickness (height) of each wiring be in the range of 0.1 to 20 µm.

As a method of forming the collective wiring, there is, for example, a method that includes mixing a binder such as fine glass particles with metal powder, which forms conductive particles, and forming the mixture in the shape of a paste; forming a coating film with the mixture so as to form a predetermined pattern by a printing method, such as a screen printing method, a dispense method, a metal mask method, an inkjet method or the like; and fusing the conductive particles by firing. For example, if the substrate is a glass substrate, firing temperature may be preferably 600°C or less and more preferably 550°C or less. Sputtering, deposition, plating, and the like may also be used as other methods of forming collective wiring. In terms of electrical conductivity, it is preferable that the volume resistivity of the collective wiring be 10⁻⁵ Ω·cm or less.

Each of the wiring protective layers 14 and 34 may include one or more glass layers made of low melting point glass, and may include one or more insulating resin layers made of a heat-resistant resin. Further, each of the wiring protective layers may include at least two of these glass layers and the insulating resin layers.

The glass layer, which may be used as the wiring protective layer, is made of low melting point glass. Lead-containing glass such as a lead borate-based glass may be generally used as the low melting point glass. However, it is more preferable that glass not containing lead be used in consideration of environmental burden. For example, low melting point glass materials, such as borosilicate bismuth salt-based/acidum boricum bismuth zinc salt-based glass materials, aluminophosphate-based/zinc phosphate-based glass materials, and borosilicate salt-based glass materials may be used. The glass layer may be formed by mixing a plasticizer or other additives in low melting point glass, which contains one or several kinds of low melting point glass materials and is used as a main ingredient, according to need for the adjustment of a coefficient of thermal expansion or viscosity; forming the mixture in the shape of a paste; applying the mixture by a method such as screen printing dispense or the like; and firing the applied mixture. The glass layer may be made to form multiple layers by using the same paste or different pastes.

An insulating resin layer, which may be used as the wiring protective layer, is made of a heat-resistant resin. The heat-resistant resin, which has heat resistance so as to withstand at least the firing of the porous oxide semiconductor layer, is selected. As the heat-resistant resin, one selected from a polyimide derivative, a silicone compound, a fluoroelastomer, a fluororesin, and the like may be used alone or several kinds of materials selected from them may be used together by mixing, laminating, or the like. One or more selected from Teflon (registered trademark)-based compounds, such as polytetrafluoroethylene, a tetrafluoroethylene-perfluoro (alkyl vinyl ether) copolymer and a tetrafluoroethylene-hexafluoropropylene copolymer, may be used as the fluororesin. Further, concern of impact fracture, crack or the like of the wiring protective layer, is reduced by applying a flexible resin material to the insulating resin layer. As a method of forming the insulating resin layer, there is a method of forming a coating film with a paste or varnish containing an insulating resin. In terms of improvement of the denseness of the insulating resin layer, it is preferable that the wiring protective layer be formed of several layers by repeating the forming of a coating film several times.

The wiring protective layer includes a glass layer made of glass ingredients. Accordingly, it may be possible to suppress the deterioration or leakage (reduction of the amount) of the electrolyte. Further, the insulating resin layer made of a heat-resistant resin is formed on the glass layer as an overcoat. Accordingly, glass ingredients in the glass layer do not come into contact with the electrolyte and it may be possible to prevent the ingredients in glass from reacting with the ingredients in the electrolytes.

Further, the glass layer prevents gas permeation. Accordingly, in order to intend to obtain only an effect of preventing gas permeation, a heat-resistant resin or a heat-resistant adhesive, which can be fired at a high temperature, does not need to be used as the insulating resin layer. In this case, there may be formed an insulating resin layer that forms an overcoat by applying an adhesive that has low heat resistance or laminating a hot-melt adhesive. In particular, if the insulating resin layer is formed by laminating the hot-melt adhesive, the poisoning of a working electrode is small. Accordingly, it may be possible to obtain good characteristics that are similar to the characteristics of a heat-resistant resin or a heat-resistant adhesive.

The low melting point glass layer and the heat-resistant resin layer may be formed by applying one or several kinds of materials several times, respectively. In terms of the compensation of defects such as pinholes generated during printing and the improvement of the denseness of the protective layer, it is more preferable that the low melting point glass layer and the heat-resistant resin layer be formed of a plurality of layers.

It is preferable that the thickness of the insulating resin layer as an overcoat of the glass layer be 1 µm or more. If the overcoat is excessively thin, the flexibility of the resin is not utilized and there is a possibility that the surface of opposing counter electrode is damaged. Further, there is a possibility that the resin layer itself may be damaged due to the mixing of foreign materials and the like or the handling during the manufacture of elements.

The wiring protective layer does not need to be formed to be excessively thick, and the total thickness of the wiring protective layer had better not exceed 100 µm.

The wiring protective layers 24 and 44 include the reflective films as described above. The reflective films further include high refractive index particles such as titanium oxide particles in the insulating resin layers or glass layers that form the above-mentioned wiring protective layers 14 and 34.

The porous oxide semiconductor layers 15, 25, 35, and 45 are formed by forming porous films by firing nanoparticles (fine particles having an average particle size of 1 to 1000 nm) of oxide semiconductors and sensitizing a dye.

One or more selected from a titanium oxide (TiO₂), a tin oxide (SnO₂), a tungsten oxide (WO₃), a zinc oxide (ZnO), a niobium oxide (Nb₂O₅) may be used as the oxide semiconductor. The thickness of the porous oxide semiconductor layer may be in the range of, for example, 0.5 to 50 µm.

As a method of forming the porous oxide semiconductor layer, an electrophoretic deposition method of immersing a substrate in a colloid solution and depositing oxide semiconductor fine particles on the substrate by electrophoresis may be applied other than applying a dispersion liquid that is obtained by dispersing for example, commercial oxide semiconductor fine particles in a desired dispersion medium, or a colloid solution that can be adjusted by a sol-gel method by a well-known coating method, such as a screen printing method, an inkjet printing method, a roll coating method, a doctor blade method, a spin coating method, or a spray coating method, after adding a desired additive according to need.

The sensitized dye, which is carried on the porous oxide semiconductor layer, is not particularly limited. The sensitized dye may be appropriately selected from a ruthenium complex or an iron complex including ligands with a bipyridine structure, a terpyridine structure, or the like; porphyrin- or phthalocyanine-based metal complexes; and an organic dye that is a derivative, such as eosin, rhodamine, coumalin, and merocyanine, according to use or a material of the oxide semiconductor porous film.

The electrode substrates 16, 26, 36, and 46 are not particularly limited. However, specifically, electrode substrates, which are formed by forming catalyst layers 16b, 26b, 36b, and 46b made of platinum, carbon, a conductive polymer or the like on the surfaces of the base materials 16a, 26a, 36a, and 46a, such as metal plates, metal foil, glass plates or the likwe, may be used as the electrode substrates. In order to improve electrical conductivity at the surfaces of the electrode substrates, another conductive layers may be formed between the base materials 16a, 26a, 36a, and 46a and the catalyst layers 16b, 26b, 36b, and 46b.

Room-temperature molten salt (ionic liquid) or an organic solvent including redox pairs may be used as an electrolyte that forms the electrolyte layers 17, 27, and 37. Further, a material that is artificially solidified by introducing an appropriate gelling agent (for example, a polymer gelling agent, a low-molecular gelling agent, various nanoparticles, carbon nanotubes or the like) into an electrolyte, so-called gel electrolyte may be used instead of the electrolyte.

The organic solvent is not particularly limited. However, one or more of acetonitrile, methoxyacetonitrile, propionitrile, methoxypropionitrile, propylene carbonate, diethyl carbonate, γ-butyrolactone, and the like are exemplified as the organic solvent. Further, one or more room-temperature molten salts are exemplified that include cations such as imidazolium-based cations, pyrrolidinium-based cations, and pyridinium-based cations; and anions, such as iodide ions, bis(trifluoromethanesulfonyl)imide anions, dicyanamide anions, and thiocyanic acid anions.

The redox pair included in the electrolyte is not particularly limited. However, the redox pair may be obtained by adding one or more of pairs of iodine/iodide ions, bromine/bromide ions, and the like. The lithium salt, quaternized imidazolium salt, tetrabutylammonium salt, and the like containing these anions may be used alone or several kinds thereof may be combined as a supply source of iodide ions or bromide ions. Additives, such as 4-tert-butyl pyridine, N-methylbenzimidazole, guanidium salt or the like, may be added to the electrolyte, according to need.

The dye-sensitized solar cell according to this embodiment can be manufactured according to, for example, the following procedure.

As shown in Figs. 1 and 2, when the collective wiring 13 and 23 and the porous oxide semiconductor layers 15 and 25 are provided on the transparent electrode substrates 11 and 21, the collective wiring 13 and 23 and the porous oxide semiconductor layers 15 and 25 are formed on the transparent conductive films 12 and 22 after the transparent conductive films 12 and 22 are formed on the electrode substrates 11 and 21. Further, the wiring protective layers 14 and 24 are formed after the collective wiring 13 and 23 are formed. Meanwhile, a transparent conductive film is formed on the collective wiring, and the collective wiring may be used as a part of a wiring protective layer. A method of immersing the substrate, on which the porous oxide semiconductor layer has been provided, in a dye solution, may be used to carry a dye on the porous oxide semiconductor layer. Further, it may be possible to obtain the dye-sensitized solar cell 10 or 20 by using the first electrode substrate 11 or 21, which comprises the collective wiring 13 or 23 and the porous oxide semiconductor layer 15 or 25 on which a dye has been carried, as working electrode and disposing the electrolyte layer 17 or 27 between the first electrode and the second electrode substrate 16 or 26 that becomes counter electrodes.

If the second electrode substrate 31, which is a counter electrode, is formed of a transparent electrode substrate as shown in Fig. 3, it may be possible to obtain the working electrode by forming the collective wiring 33 and the porous oxide semiconductor layer 35 on the first electrode substrate 36, forming the wiring protective layer 34, and carrying a dye to the porous oxide semiconductor layer 35. Furthermore, it may be possible to obtain the dye-sensitized solar cell 30 by using the second electrode substrate 31, which comprisestransparent conductive film 32, as the counter electrode and disposing the electrolyte layer 37 between the working electrode and the counter electrode.

A method of disposing the electrolyte layer between both the electrode substrates is not particularly limited. However, if an electrolyte is used, there may be used a method of making the working electrode and the counter electrode face each other, sealing the peripheries of both the electrodes by a resin, an adhesive or the like, and injecting an electrolyte through an injection hole that is appropriately formed. Further, if a gel electrolyte is used, there may be used a method of applying the gel electrolyte onto the working electrode and attaching the counter electrode to the working electrode on which the gel electrolyte has been applied.

If the film 18 or 38 changing the direction of incident light is provided on the surface 11a or 31a of the transparent electrode substrate 11 or 31 as described in the first and third embodiments, the film bodies may be provided on the surfaces of the substrates before the working electrode and the counter electrode face each other and may be provided after the working electrode and the counter electrode face each other.

If the film for changing the direction of incident light also functions as a wiring protective layer as described in the second and fourth embodiments, a film for changing the direction of incident light may be formed as a wiring protective layer.

Even in any case, the film for changing the direction of incident light is provided at a position corresponding to the wiring part. Accordingly, it may be possible to suppress the energy loss of incident light and to improve power generation efficiency.

Furthermore, in each of the first to fourth embodiments, an incident light direction changing part is the film. However, the incident light direction changing part is not limited to the film. For example, the first electrode substrate, the wiring part, or a diffraction grating pattern formed on the second electrode substrate may be used as the incident light direction changing part.

Further, in each of the first to fourth embodiments, the wiring part includes the collective wiring and the wiring protective layer. However, the wiring part may be formed of only the collective wiring.

### EXAMPLES

The present invention will be described in detail below with reference to examples. Meanwhile, the present invention is not limited to these examples.

### (Manufacture of dye-sensitized solar cell)

A glass substrate (which had a size of 140 mm square and on which a FTO film as a transparent conductive film was formed) was prepared, and a silver circuit pattern was formed in a grid shape on the FTO film by screen printing. The form of the circuit pattern was designed so as to have a width of 300 µm and a thickness of 10 µm. A silver paste, which had a volume resistivity of 3×10⁻⁶ Ω·cm after sintering, was used as a silver paste for printing, and was dried at a temperature of 130°C after being printed. Further, the silver circuit pattern was sintered at a maximum temperature of 510°C, so that a circuit was formed.

After that, a low melting point glass paste as a first wiring protective material was applied and overlapped with a circuit forming portion to completely cover the silver circuit pattern, so that a print coating film made of glass was formed. The design width of the first wiring protective layer was set to 500 µm, and a coating film was formed by screen printing while the print coating film was aligned with the silver circuit pattern by using a CCD camera. After the print coating film was dried at a temperature of 130°C, a paste containing TiO₂ nanoparticles was applied to portions, where the silver circuit and a wiring protective layer were not formed, on the FTO layer of the electrode substrate by screen printing and was dried. After the drying of these, the first wiring protective layer (only a portion where application was performed one time) and the porous oxide semiconductor layer were sintered at a maximum temperature of 500°C. Furthermore, in order to increase the thickness of the first wiring protective layer, the first wiring protective layer was formed by repeating the formation and sintering of the print coating film, which was made of glass, several times on the portion where application was performed one time.

In addition, resin liquid (polyimide varnish) of a heat-resistant resin as a second wiring protective material was applied so as to completely cover the first wiring protective layer, a resin coating film was treated at a maximum temperature of 350°C, and this was repeated, so that a second wiring protective layer was formed. The design width of the second wiring protective layer was set to 800 µm, and a coating film was formed by screen printing while the second wiring protective layer was aligned with the silver circuit pattern by using a CCD camera.

In addition, immersion was performed in an acetonitrile/t-butanol solution of ruthenium-bipyridine complex (N719 dye) for one day or more days and the dye was carried, so that a photoelectrode was formed.

Titanium (Ti) foil on which a platinum (Pt) layer was formed by sputtering was used as a counter electrode. An electrolyte solution including iodine redox couples was spread on the photoelectrode in a circulating purification type globe box that was filled with inert gas. Then, the photoelectrode was laminated so as to face the counter electrode. After that, the peripheries of the elements were sealed by an ultraviolet curable resin.

### (Comparative example 1)

Comparative example 1 is a dye-sensitized solar cell that is manufactured by only the above-mentioned process without forming a film for changing the direction of incident light. In this case, photoelectric conversion efficiency was 5.18%.

### (Example 1)

In Example 1, a diffusion film (having a transmittance of 85% and a diffusion angle of 60°) having an isotropic diffusion characteristic was attached to a position on the surface of the substrate of the window electrode facing the silver circuit pattern, that is, the surface on the opposite side of the silver circuit pattern with respect to the substrate of the window electrode. In this case photoelectric conversion efficiency was 5.31%. An improvement ratio of the conversion efficiency of Example 1 to that of Comparative example 1 was about 2.5%.

### (Example 2)

In Example 2, a diffusion film was formed by applying diffusion ink for a light guide plate at a position on the surface of the substrate of the window electrode facing the silver circuit. In this case photoelectric conversion efficiency was 5.30%. An improvement ratio of the conversion efficiency of Example 2 to that of Comparative example 1 was about 2.3%.

### (Example 3)

In Example 3, a diffraction grating, which corresponded to a dispersion angle of 36° and 1000 lines/mm, was formed at a position on the surface of the substrate of the window electrode facing the silver circuit. In this case photoelectric conversion efficiency was 5.28%. An improvement ratio of the conversion efficiency of Example 3 to that of Comparative example 1 was about 1.9%.

### (Example 4)

In Example 4, a fluorescent coating film was formed by attaching a mending tape (manufactured by Sumitomo 3M Ltd.), which was colored by yellow fluorescent coating (yellow highlighter pen manufactured by Zebra Co., Ltd.), at a position on the surface of the substrate of the window electrode facing the silver circuit. In this case photoelectric conversion efficiency was 5.24%. An improvement ratio of the conversion efficiency of Example 4 to that of Comparative example 1 was about 1.2%.

### (Example 5, not forming part of the invention)

In Example 5, a reflective film was formed on the surface of the wiring protective layer by using the mixture of 5wt% of titania particles (having an average particle size of 400 nm) and a polyimide varnish used as a second wiring protective material while a low melting point glass paste used as a first wiring protective material was the same as that of Comparative example 1. In this case photoelectric conversion efficiency was 5.25%. An improvement ratio of the conversion efficiency of Example 5 to that of Comparative example 1 was about 1.4%.

### (Results of measurement of photoelectric conversion efficiency)

Here, photoelectric conversion efficiency is a measured value of the energy efficiency of photoelectric conversion under 1Sun pseudo sunlight (AM1.5). The results of measurement of the photoelectric conversion efficiency were summarized as shown in Table 1.

**[Table 1]**

| | Incident light direction changing part | Wiring protective layer | Conversion efficiency |
|---|---|---|---|
| Example 1 | Diffusion film | PI ink and glass | 5.31% |
| Example 2 | Diffusion ink | PI ink and glass | 5.30% |
| Example 3 | Diffraction grating | PI ink and glass | 5.28% |
| Example 4 | Fluorescent coating film | PI ink and glass | 5.24% |
| Example 5 | Reflective film | PI ink (containing 5wt% of titania particles) and glass | 5.25% |
| Comparative example 1 | None | PI ink and glass | 5.18% |

As described in the above results, in Examples 1 to 5, conversion efficiency was improved by about 1.2 to 2.5% with respect to the conversion efficiency of Comparative example 1. Meanwhile, a solar cell cell having an aperture ratio of 90% was used in the examples. Accordingly, even though the incident light entering a wiring portion could be completely used, the limitation of the improvement ratio of conversion efficiency is 11%. Accordingly, according to the examples, it may be possible to use about 10 to 23% of incident light, which enters the wiring portion, for power generation.

### INDUSTRIAL APPLICABILITY

As long as the present invention is a dye-sensitized solar cell that includes wiring parts adjacent to a porous oxide semiconductor layer, the present invention may be used to improve conversion efficiency without being limited to a form, such as a cell, an array, and a module.

## Claims

1. A dye-sensitized solar cell (10, 20, 30, 40) comprising:
a first electrode substrate (11, 21, 31, 41) that includes a porous oxide semiconductor layer (15, 25, 35, 45) and a wiring part (19, 29, 39) on a side of one surface thereof, a dye being carried on the porous oxide semiconductor layer (15, 25, 35, 45), and the wiring part (19, 29, 39) being provided at a portion adjacent to the porous oxide semiconductor layer (15, 25, 35, 45);
a second electrode substrate (16, 26, 36, 46) that is disposed so as to face the porous oxide semiconductor layer (15, 25, 35, 45) of the first electrode substrate (11, 21, 31, 41); and
an electrolyte layer (17, 27, 37, 47) that is disposed at least at a part of a gap between the first and second electrode substrates (11, 21, 31, 41) and (16, 26, 36, 46),
wherein at least one of the first electrode substrate (11, 21, 31, 41) and the second electrode substrate (16, 26, 36, 46) is provided with an incident light direction changing part (18, 28, 38) that changes the direction of incident light (L) at a position corresponding to the wiring part (19, 29, 39);
the dye-sensitized solar cell being **characterized in that** the incident light direction changing part (18, 28, 38) is a film;
the width of the film (18, 28, 38) is larger than the width of the wiring part (19, 29, 39) and the film (18, 28, 38) is disposed in a range that does not overlap the adjacent porous oxide semiconductor layer (15, 25, 35, 45).

2. The dye-sensitized solar cell (10, 20, 30, 40) according to claim 1,
wherein the film (18, 28, 38) is at least one of a diffusion film, a diffraction grating film, a fluorescent coating film, and a reflective film.

3. The dye-sensitized solar cell (10, 20, 30, 40) according to claim 1 or 2,
wherein the incident light direction changing part (18, 28, 38) is provided on a line, which connects the first electrode substrate (11, 21, 31, 41), the wiring part (19, 29), and the second electrode substrate (16, 26, 36, 46), and on a line along a thickness direction of the first or second electrode substrate (11, 21, 31, 41) or (16, 26, 36, 46).

4. The dye-sensitized solar cell (10) according to claim 1 or 2,
wherein the incident light direction changing part (18) is provided on the opposite side of the wiring part (19) with respect to the first electrode substrate (11).

5. The dye-sensitized solar cell (20) according to claim 1 or 2,
wherein the first electrode substrate (21) is a transparent electrode substrate,
the wiring part (29) includes a collective wiring (23) and a wiring protective layer (24) that is provided so as to cover the collective wiring (23), and
the wiring protective layer (24) includes the incident light direction changing part (28).

6. The dye-sensitized solar cell (20) according to claim 1 or 2,
wherein the first electrode substrate (21) is a transparent electrode substrate,
the wiring part (29) includes a collective wiring (23) and a wiring protective layer (24) that is provided so as to cover the collective wiring (23), and
the incident light direction changing part (28) is provided between the wiring part (29) and the first electrode substrate (21).

7. The dye-sensitized solar cell (30) according to claim 1 or 2,
wherein the second electrode substrate (31) is a transparent electrode substrate, and
the incident light direction changing part (38) is provided on the opposite side of the first electrode substrate (36) with respect to the second electrode substrate (31).

8. The dye-sensitized solar cell (40) according to claim 1 or 2,
wherein the second electrode substrate (41) is a transparent electrode substrate,
the wiring part (49) includes a collective wiring (43) and a wiring protective layer (44) that is provided so as to cover the collective wiring (43), and
the wiring protective layer (44) includes the incident light direction changing part.

## Patentansprüche

1. Farbstoffsensibilisierte Solarzelle (10, 20, 30, 40) umfassend:
ein erstes Elektrodensubstrat (11, 21, 31, 41), das eine poröse Oxid-Halbleiterschicht (15, 25, 35, 45) und einen Verdrahtungsteil (19, 29, 39) auf einer Seite einer von dessen Oberflächen enthält, wobei auf die poröse Oxid-Halbleiterschicht (15, 25, 35, 45) ein Farbstoff aufgetragen ist, und der Verdrahtungsteil (19, 29, 39) auf einem der porösen Oxid-Halbleiterschicht (15, 25, 35, 45) benachbarten Abschnitt angebracht ist;
ein zweites Elektrodensubstrat (16, 26, 36, 46), das so angeordnet ist, dass es der porösen Oxid-Halbleiterschicht (15, 25, 35, 45) des ersten Elektrodensubstrats (11, 21, 31, 41) zugewandt ist; und
eine Elektrolytschicht (17, 27, 37, 47), die zumindest an einem Teil eines Zwischenraums zwischen dem ersten (11, 21, 31, 41) und dem zweiten Elektrodensubstrat (16, 26, 36, 46) angeordnet ist, und
wobei zumindest eines von dem ersten Elektrodensubstrat (11, 21, 31, 41) und dem zweiten Elektrodensubstrat (16, 26, 36, 46) mit einem Richtungsänderungsteil für einfallendes Licht (18, 28, 38) vorgesehen ist, der die Richtung von auf eine Position entsprechend dem Verdrahtungsteil (19, 29, 39) einfallendem Licht (L) ändert;
wobei die farbstoffsensibilisierte Solarzelle **dadurch gekennzeichnet ist dass** der Richtungsänderungsteil für einfallendes Licht (18, 28, 38) ein Film ist; wobei
die Breite des Films (18, 28, 38) größer ist als die Breite des Verdrahtungsteils (19, 29, 39) und der Film (18, 28, 38) in einem Bereich angeordnet ist, der mit der benachbarten porösen Oxid-Halbleiterschicht (15, 25, 35, 45) nicht überlappt.

2. Farbstoffsensibilisierte Solarzelle (10, 20, 30, 40) nach Anspruch 1,
in der der Film (18, 28, 38) mindestens einer ist von einem Diffusionsfilm, einem Beugungsgitter-Film, einem fluoreszierenden Beschichtungsfilm und einem Reflexionsfilm.

3. Farbstoffsensibilisierte Solarzelle (10, 20, 30, 40) nach Anspruch 1 oder 2,
wobei der Richtungsänderungsteil für einfallendes Licht (18, 28, 38) auf einer Linie angebracht ist, die das erste Elektrodensubstrat (11, 21, 31, 41), den Verdrahtungsteil (19, 29), und das zweite Elektrodensubstrat (16, 26, 36, 46) verbindet, und auf einer Linie in Dickenrichtung des ersten (11, 21, 31, 41) oder zweiten Elektrodensubstrats (16, 26, 36, 46).

4. Farbstoffsensibilisierte Solarzelle (10) nach Anspruch 1 oder 2,
in der der Richtungsänderungsteil für einfallendes Licht (18) auf der gegenüberliegenden Seite des Verdrahtungsteils (19) gegenüber dem ersten Elektrodensubstrat (11) angebracht ist.

5. Farbstoffsensibilisierte Solarzelle (20) nach Anspruch 1 oder 2,
in der das erste Elektrodensubstrat (21) ein transparentes Elektrodensubstrat ist,
der Verdrahtungsteil (29) eine Kollektivverdrahtung (23) sowie eine Verdrahtungsschutzschicht (24) aufweist, welche so angebracht ist, dass sie die Kollektivverdrahtung (23) abdeckt, und
die Verdrahtungsschutzschicht (24) den Richtungsänderungsteil für einfallendes Licht (28) umfasst.

6. Farbstoffsensibilisierte Solarzelle (20) nach Anspruch 1 oder 2,
in der das erste Elektrodensubstrat (21) ein transparentes Elektrodensubstrat ist,
der Verdrahtungsteil (29) eine Kollektivverdrahtung (23) sowie eine Verdrahtungsschutzschicht (24) umfasst, die angebracht ist, um die Kollektivverdrahtung (23) abzudecken, und
der Richtungsänderungsteil für einfallendes Licht (28) zwischen dem Verdrahtungsteil (29) und dem ersten Elektrodensubstrat (21) angebracht ist.

7. Farbstoffsensibilisierte Solarzelle (30) nach Anspruch 1 oder 2,
in der das zweite Elektrodensubstrat (31) ein transparentes Elektrodensubstrat ist, und
der Richtungsänderungsteil für einfallendes Licht (38) in Bezug auf das zweite Elektrodensubstrat (31) auf der gegenüberliegenden Seite des ersten Elektrodensubstrats (36) angebracht ist.

8. Farbstoffsensibilisierte Solarzelle (40) nach Anspruch 1 oder 2,
in der das zweite Elektrodensubstrat (41) ein transparentes Elektrodensubstrat ist,
der Verdrahtungsteil (49) eine Kollektivverdrahtung (43) sowie eine Verdrahtungsschutzschicht (44) umfasst, die angebracht ist, um die Kollektivverdrahtung (43) abzudecken,
und die Verdrahtungsschutzschicht (44) den Richtungsänderungsteil für einfallendes Licht enthält.

## Revendications

1. Cellule solaire à colorant (10, 20, 30, 40) comprenant :
un premier substrat d'électrode (11, 21, 31, 41) qui comporte une couche semi-conductrice d'oxyde poreuse (15, 25, 35, 45) et une partie de câblage (19, 29, 39) sur un côté d'une surface de celui-ci, un colorant étant porté sur la couche semi-conductrice d'oxyde poreuse (15, 25, 35, 45), et la partie de câblage (19, 29, 39) étant prévue au niveau d'une partie adjacente à la couche semi-conductrice d'oxyde poreuse (15, 25, 35, 45) ;
un deuxième substrat d'électrode (16, 26, 36, 46) qui est disposé de manière à faire face à la couche semi-conductrice d'oxyde poreuse (15, 25, 35, 45) du premier substrat d'électrode (11, 21, 31, 41) ; et
une couche d'électrolyte (17, 27, 37, 47) qui est disposée au niveau d'au moins une partie d'un espace entre les premier et deuxième substrats d'électrode (11, 21, 31, 41) et (16, 26, 36, 46),
dans laquelle au moins l'un parmi le premier substrat d'électrode (11, 21, 31, 41) et le deuxième substrat d'électrode (16, 26, 36, 46) est doté d'une partie de changement de direction de lumière incidente (18, 28, 38) qui change la direction de la lumière incidente (L) à une position correspondant à la partie de câblage (19, 29, 39) ;
la cellule solaire à colorant étant **caractérisée en ce que** la partie de changement de direction de lumière incidente (18, 28, 38) est un film ;
la largeur du film (18, 28, 38) est supérieure à la largeur de la partie de câblage (19, 29, 39) et le film (18, 28, 38) est disposé dans une plage qui ne chevauche pas la couche semi-conductrice d'oxyde poreuse adjacente (15, 25, 35, 45).

2. Cellule solaire à colorant (10, 20, 30, 40) selon la revendication 1,
dans laquelle le film (18, 28, 38) est au moins l'un parmi : un film de diffusion, un film à réseau de diffraction, un film à revêtement fluorescent, et un film réfléchissant.

3. Cellule solaire à colorant (10, 20, 30, 40) selon la revendication 1 ou 2,
dans laquelle la partie de changement de direction de lumière incidente (18, 28, 38) est prévue sur une ligne, qui relie le premier substrat d'électrode (11, 21, 31, 41), la partie de câblage (19, 29), et le deuxième substrat d'électrode (16, 26, 36, 46), et sur une ligne le long d'une direction de l'épaisseur du premier ou du deuxième substrat d'électrode (11, 21, 31, 41) ou (16, 26, 36, 46).

4. Cellule solaire à colorant (10) selon la revendication 1 ou 2,
dans laquelle la partie de changement de direction de lumière incidente (18) est prévue sur le côté opposé de la partie de câblage (19) par rapport au premier substrat d'électrode (11).

5. Cellule solaire à colorant (20) selon la revendication 1 ou 2,
dans laquelle le premier substrat d'électrode (21) est un substrat d'électrode transparent,
la partie de câblage (29) comporte un câblage collectif (23) et une couche de protection de câblage (24) qui est prévue de manière à couvrir le câblage collectif (23), et
la couche de protection de câblage (24) comporte la partie de changement de direction de lumière incidente (28).

6. Cellule solaire à colorant (20) selon la revendication 1 ou 2,
dans laquelle le premier substrat d'électrode (21) est un substrat d'électrode transparent,
la partie de câblage (29) comporte un câblage collectif (23) et une couche de protection de câblage (24) qui est prévue de manière à couvrir le câblage collectif (23), et
la partie de changement de direction de lumière incidente (28) est prévue entre la partie de câblage (29) et le premier substrat d'électrode (21).

7. Cellule solaire à colorant (30) selon la revendication 1 ou 2,
dans laquelle le deuxième substrat d'électrode (31) est un substrat d'électrode transparent, et
la partie de changement de direction de lumière incidente (38) est prévue sur le côté opposé du premier substrat d'électrode (36) par rapport au deuxième substrat d'électrode (31).

8. Cellule solaire à colorant (40) selon la revendication 1 ou 2,
dans laquelle le deuxième substrat d'électrode (41) est un substrat d'électrode transparent,
la partie de câblage (49) comporte un câblage collectif (43) et une couche de protection de câblage (44) qui est prévue de manière à couvrir le câblage collectif (43) ; et
la couche de protection de câblage (44) comporte la partie de changement de direction de lumière incidente.
